(19) Europäisches Patentamt
European Patent Office
Office européen des brevets

(11) **EP 4 233 177 B1**

(12) **EUROPEAN PATENT SPECIFICATION**

(45) Date of publication and mention
of the grant of the patent:
**25.06.2025 Bulletin 2025/26**

(21) Application number: **20961262.1**

(22) Date of filing: **16.11.2020**

(51) International Patent Classification (IPC):
*H03M 13/11* (2006.01)    *H03M 13/03* (2006.01)
*G06F 11/10* (2006.01)    *H03M 13/00* (2006.01)
*H03M 13/37* (2006.01)

(52) Cooperative Patent Classification (CPC):
**H03M 13/1111; H03M 13/1174; H03M 13/3784;
H03M 13/613; H03M 13/6502**

(86) International application number:
**PCT/CN2020/129139**

(87) International publication number:
**WO 2022/099708 (19.05.2022 Gazette 2022/20)**

(54) **EFFICIENT DECODING OF GLDPC CODES**

EFFIZIENTE DECODIERUNG VON GLDPC CODES

DÉCODAGE EFFICACE DE CODES GLDPC

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**30.08.2023 Bulletin 2023/35**

(73) Proprietor: **Huawei Technologies Co., Ltd.
Shenzhen, Guangdong 518129 (CN)**

(72) Inventors:
• **BENNATAN, Amir
Shenzhen, Guangdong 518129 (CN)**
• **CARASSO, David
Shenzhen, Guangdong 518129 (CN)**
• **BAR, Ilan
Shenzhen, Guangdong 518129 (CN)**
• **KISILEV, Pavel
Shenzhen, Guangdong 518129 (CN)**
• **ZHANG, Mu
Shenzhen, Guangdong 518129 (CN)**
• **ZHANG, Xu
Shenzhen, Guangdong 518129 (CN)**

(74) Representative: **Pfenning, Meinig & Partner mbB
Patent- und Rechtsanwälte
Theresienhöhe 11a
80339 München (DE)**

(56) References cited:
CN-A- 111 164 897    CN-A- 111 279 618
US-A1- 2004 088 645    US-A1- 2016 182 087
US-A1- 2018 343 020    US-A1- 2020 099 395

• **ASHIKHMIN A ET AL: "Simple MAP Decoding of
First-Order Reed-Muller and Hamming Codes",
IEEE TRANSACTIONS ON INFORMATION
THEORY, IEEE, USA, vol. 50, no. 8, 1 August 2004
(2004-08-01), pages 1812 - 1818, XP011115250,
ISSN: 0018-9448, DOI: 10.1109/TIT.2004.831835**
• **NAZAROV L E ET AL: "Use of fast Walsh-
Hadamard transformation for optimal symbol-by-
symbol binary block-code decoding",
ELECTRONICS LETTERS, THE INSTITUTION OF
ENGINEERING AND TECHNOLOGY, GB, vol. 34,
no. 3, 5 February 1998 (1998-02-05), pages 261 -
262, XP006009255, ISSN: 0013-5194, DOI:
10.1049/EL:19980186**
• **HARTMANN CARLOS R P ET AL: "An optimum
symbpl-by-symbol decoding rule for linear
codes", IEEE TRANSACTIONS ON
INFORMATION THEORY, IEEE, USA, vol. 22, no.
5, 1 September 1976 (1976-09-01), pages 514 -
517, XP002480327, ISSN: 0018-9448, DOI:
10.1109/TIT.1976.1055617**

**(Cont. next page)**

- **DAVID FORNEYJR G: "Codes on Graphs: Normal Realizations", IEEE TRANSACTIONS ON INFORMATION THEORY, IEEE, USA, vol. 47, no. 2, 1 February 2001 (2001-02-01), XP011027869, ISSN: 0018-9448**
- **HABANABASHAKA JEAN D'AMOUR: "GLDPC Decoder on FPGA and Performance Evaluation over Binary Erasure Channel", CHINESE MASTER'S THESES FULL-TEXT DATABASE, 1 June 2018 (2018-06-01), pages 1 - 65, XP055931107**

## EP 4 233 177 B1

**Description**

<u>BACKGROUND</u>

Some embodiments relate to a digital data encoding and decoding for error correction and, more particularly, but not exclusively, to Generalized Low Density Parity-Check (GLDPC) decoding.

The media used for digital data storage and communication is noisy, and maximizing the utility of communication channels depends on noise management. Forward error correction (FEC) enables recovering data bits that would otherwise be lost due to noise, and serve as essential part in storage and communication systems. The objective of FEC system design is to reduce bit error rate (BER) at the decoder output.

FEC systems consist of an encoder and a decoder. The encoder receives sequences of binary bits known as messages, and may add parity bits, calculated based on the messages' bits. The parity bits may be calculated by exclusive or (XOR) gates, by software or hardware using pre-made matrices, and/or the like, thereby generating the codeword which includes the message and the parity bits. Examples of noisy media comprise wireless communication channels, subject to noise from variety of other sources, flash memory, which may be subject to voltage fluctuations, fiber-optic communications subject to optical distortions, and copper wires that may be subject to crosstalk, capacitance, wave reflections, and the like. The codewords are stored or transmitted through a noisy medium, and a decoder may obtain a modified codeword, and attempt to reproduce an exact codeword.

Longer codewords, or block lengths, enable better ratio of message bits to parity bits while maintaining the ability to correct a number of errors, at the cost of more complex calculations. BER is also subject, to channel signal to noise ratio (SNR), and the code rate. Achieving a low BER at high code rates with low SNR and complexity and short block lengths enable bandwidth efficiency, energy efficiency, low cost, low calculation incurred latency, and low power consumption. The encoder and decoder have a compatible code, for example, when the encoder applies a given generator matrix for encoding, the decoder may apply the inverse of the given generator matrix as the parity check matrix. Linear block codes are defined by a binary generator matrix G such that the transmitted codeword c is obtained from the message bit vector m by the equation: $c = G \cdot m \bmod 2$. Low Density Parity-Check (LDPC) codes are characterized by sparse parity check matrices, i.e. having a low density of 1's among the binary matrix elements. A useful representation of LDPC codes involves a bipartite graph, namely a Tanner graph. A decoder may recover a noisy codeword by executing an iterative algorithm over the Tanner graph. Several researchers have considered generalized LDPC (GLDPC), The GLDPC codes are also represented by a bipartite Tanner graph. However, in GLDPC Tanner graph, the parity check nodes are replaced by component nodes. Each component node is associated with a component code, which may be a short linear block code. While decoding of GLDPC codes is conceptually the same as decoding of LDPC codes, the expressions for computing the iterative algorithm messages at each component node are more complex.

For a given GLDPC code, the above-mentioned decoder had a complexity of $O(d \cdot 2^{(1-r)d})$, where r is the rate of the component code, and d is the degree of the component node. This prohibitive complexity imposes an obstacle to the application of GLDPC codes, despite of the potential improvement in error resilience that two levels of encoding could account for.

US 2004/088645 A1 discloses mechanisms for maximum a posteriori (MAP) decoding of signals encoded using error correction codes, and, more particularly, to MAP decoding of signals encoded using binary Hamming codes and related error correction codes.

ASHIKHMIN A ET AL: "Simple MAP Decoding of First-Order Reed-Muller and Hamming Codes", IEEE TRANSACTIONS ON INFORMATION THEORY, IEEE, USA, vol. 50, no. 8, 1 August 2004, pages 1812-1818, ISSN: 0018-9448, proposes new MAP decoding algorithms for binary and nonbinary RM-1 and Hamming codes. The proposed algorithms have complexities proportional to q/sup 2/n log/sub q/n, where q is the alphabet size. In particular, for the binary codes this yields complexity of order n log n.

NAZAROV L E ET AL: "Use of fast Walsh-Hadamard transformation for optimal symbol-by-symbol binary block-code decoding", ELECTRONICS LETTERS, THE INSTITUTION OF ENGINEERING AND TECHNOLOGY, GB, vol. 34, no. 3, 5 February 1998, pages 261-262, ISSN: 0013-5194, discloses procedure for the optimal symbol-by-symbol binary block-code decoding using the spectral Walsh-Hadamard transformation.

HARTMANN CARLOS R P ET AL: "An optimum symbol-by-symbol decoding rule for linear codes", IEEE TRANSACTIONS ON INFORMATION THEORY, IEEE, USA, vol. 22, no. 5, 1 September 1976, pages 514-517, ISSN: 0018-9448, discloses decoding rule which minimizes the probability of symbol error over a time-discrete memoryless channel for any linear error-correcting code when the codewords are equiprobable.

DAVID FORNEYJR G: "Codes on Graphs: Normal Realizations", IEEE TRANSACTIONS ON INFORMATION THEORY, IEEE, USA, vol. 47, no. 2, 1 February 2001, ISSN: 0018-9448, discloses efficient cyclic and cycle-free realizations of Reed-Muller (RM) codes.

BRIEF DESCRIPTION OF THE SEVERAL VIEWS OF THE DRAWINGS

Some embodiments are herein described, by way of example only, with reference to the accompanying drawings. With specific reference now to the drawings in detail, it is stressed that the particulars shown are by way of example and for purposes of illustrative discussion of embodiments. In this regard, the description taken with the drawings makes apparent to those skilled in the art how embodiments may be practiced.

In the drawings:

FIG. 1 is an exemplary layout of typical components of a decoder system;

FIG. 2A is an exemplary layout of a typical FEC system and its operation across a noisy communication channel and/or a noisy storage medium;

FIG. 2B is another exemplary schematic diagram of a typical FEC system and its operation across a noisy communication channel;

FIG. 3A is an exemplary tanner graph optionally implemented by a decoder, according to some embodiments of the present invention;

FIG. 3B is an exemplary depiction of a data flow of a method optionally employed by a decoder, according to some embodiments of the present invention;

FIG. 4 is a schematic diagram of an exemplary generalized sum-product based component node decoder, according to some embodiments of the present invention;

FIG. 5A is a schematic diagram of an exemplary method of training the neural network of the Generalized min-sum component node decoder, according to some embodiments of the present invention;

FIG. 5B is another schematic diagram of an exemplary generalized sum-product based component node decoder, according to some embodiments of the present invention;

FIG. 6A is yet another schematic diagram of an exemplary generalized sum-product based component node decoder, according to some embodiments of the present invention;

FIG. 6B is an additional schematic diagram of an exemplary generalized sum-product based component node decoder, according to some embodiments of the present invention;

FIG. 7 is a schematic diagram of an exemplary generalized min-sum based component node decoder, according to some embodiments of the present invention;

FIG. 8 is an exemplary GLDPC parity check matrix, with the associated LDPC and the associated component parity check matrix, according to some embodiments of the present invention;

FIG. 9 is an exemplary process diagram of a method optionally employed by a decoder, according to some embodiments of the present invention; and

FIG. 10 depicts results of simulations using legacy and disclosed implementations of GLDPC parity codes, according to some embodiments of the present invention.

DETAILED DESCRIPTION

It is an object of the present disclosure, in some embodiments thereof, to provide a decoder device, a method, a computer readable medium, and an integrated circuit for efficient decoding of GLDPC codes.

The foregoing and other objects are achieved by the features of the independent claims. Further implementation forms are apparent from the dependent claims, the description and the figures.

Other systems, methods, features, and advantages of the present disclosure will be or become apparent to one with skill in the art upon examination of the following drawings and detailed description.

Unless otherwise defined, all technical and/or scientific terms used herein have the same meaning as commonly understood by one of ordinary skill in the art to which embodiments. Although methods and materials similar or equivalent to those described herein can be used in the practice or testing of embodiments, exemplary methods and/or materials are described below. In case of conflict, the patent specification, including definitions, will control. In addition, the materials, methods, and examples are illustrative only and are not intended to be necessarily limiting.

Some embodiments relate to a digital data encoding and decoding for error correction and, more particularly, but not exclusively, to Generalized Low Density Parity-Check (GLDPC) decoding.

According to some embodiments of the present invention there are provided communication systems in which systems and methods attempt to overcome noise resulting from communication channel fluctuations. According to some embodiments of the present invention there is provided a system, which applies to FEC systems and includes a description of a decoder, together with several extensions, which may be employed by an FEC system over a noisy analog channel. An FEC system receives binary messages, which are fed into an encoder. The encoder encodes binary messages by employing a mapping of strings of message bits to strings of coded bits (the codewords). Optionally, the mapping relies on a known result stating that for linear codes, for each codeword there exists an equivalent representation, in which a

respective codeword is assembled by appending parity bits to message bits. It is assumed equivalent representations of codewords are used hereof.

Codewords are then stored on a medium such as a solid-state drive (SSD) or transmitted into a communication channel. Channel outputs are then received by a decoder, which may apply a parity matrix in order to produce an exact replica of each message. A block length of a code is hereby defined as a length of each codeword. Soft decoders are defined as decoders that require information beyond what is given by binary inputs.

A decoder which may be applied to perform Soft-In Soft-Out (SISO) decoding according to some embodiments of the present invention, may be based on a tanner graph representation, comprising variable nodes and component nodes. GLDPC decoder may comprise component nodes instead of parity nodes of LDPC decoders.

LDPC codes are used in storage devices and communications systems. LDPC codes are theoretically able to approach the theoretical bounds, as found by Shannon. However, the efficiency is compromised for practical considerations, such as limited computational resources, logic complexity, power consumption, real time performance requirements, and manufacturing costs. High power consumption, large silicon area for dedicated circuitry or powerful processors may incur manufacturing costs, power consumption, and may be even more prohibitive on mobile devices, where dimensions are limited and battery draining may limit the usability. Complex calculation may incur delays on disk access and real time communication.

GLDPC encoding may provide better error resilience with a smaller proportion of parity bits, however decoding of GLDPC codes is complex. The optimal SISO decoding of the component code within the GLDPC iterative decoder is formulated as follows. The inputs $m_1, m_2, ..., m_{j-1}, m_j, m_{j+1}, ..., m_d$ denote the incoming extrinsic messages at a component node of degree d, and $n_1, n_2, ..., n_{j-1}, n_j, n_{j+1}, ..., n_d$ denote the computed outgoing messages. The expression for $n_j$ is given by:

$$n_j = \sigma^{-1}\left(\frac{\rho_0{}^j\left(m_1\,...,m_{j-1},m_{j+1}\,...,m_d\right)}{\rho_0{}^j\left(m_1\,...,m_{j-1},m_{j+1}\,...,m_d\right) + \rho_1{}^j\left(m_1\,...,m_{j-1},m_{j+1}\,...,m_d\right)}\right)$$

$$j = 1, ..., d$$

Where:

$$\rho_b{}^j\left(m_1\,...,m_{j-1},m_{j+1}\,...,m_d\right) = \sum_{\substack{c \in C \\ c_j = b}} \prod_{\substack{i=1 \\ i \neq j}}^{N} \sigma\left(-m_j\right)^{c_i}\left(1 - \sigma\left(-m_j\right)\right)^{(1-c_i)}$$

$$b \in \{0, 1\}$$

Where $\sigma\,(\cdot)$ or $\sigma(\cdot)$ denotes the sigmoid function, and $\sigma^{-1}(\cdot)$ or $\sigma^{-1}(\cdot)$ its inverse.

Additionally, d is the degree of the component node, and C is the set of all codewords of the component code. Values $m_1, ..., m_d$ denote the incoming messages from all neighboring variable nodes and $n_j$ is the output message along the j'th edge, which is to be sent to the variable node adjacent to that edge.

It can be shown that the generic equation for the extrinsic output message can be also derived as $n_j = \log\left(f_j(\underline{0})\right) - \log\left(f_j(\underline{h}_j)\right)$ where:

$$f_j\left(\underline{k}\right) = \text{IDFT}\left(\prod_{\substack{i=1 \\ i \neq j}}^{n} \text{DFT}(P_{\underline{U}_i})\right)\Bigg|_{\underline{k}}$$

and where the DFT is a $2^p$ dimensional DFT, and can thus be implemented through a fast Fourier transform (FFT) or fast Walsh-Hadamard transform (FWHT).

The random vector $\underline{U}_j = \underline{h}_j x_i$, where $x_i$ is the i'th transmitted bit is in the subspace $\{0,1\}^p$, and we can write for this vector of size $2^p$ elements

This stage is the *Vectorize* stage since it vectorizes the P(y=0) or and P(y=1) input values to a vector of $2^p$ elements.

The complexity may be measured by floating point multiplications per outgoing message, and the performance may be measured by the maximum level of noise that may be corrected by a GLDPC decoder that applies the component SISO decoder.

For a given GLDPC code, the above-mentioned decoder had a complexity of $O(d \cdot 2^{rd})$, where r is the rate of the component code. This complexity may be prohibitively large. While lower-complexity decoders exist, their complexity/performance tradeoff typically also prohibits practical implementation.

The disclosed method for low-complexity component decoders has several variants based on generalization of equivalent algorithms used in decoding of LDPC codes.

Some variants are based on generalized sum-product, a low-complexity implementation of the generalized sum-product decoder and the second variant is a generalized min-sum, a low-complexity approximation of the decoder, which comprises deep neural networks.

Embodiments of the present disclosure comprises converting each scalar $m_i$ to a $2^p$ dimensional vector $M_i$ where p is the number of parity bits in the component code's parity check matrix. The vector may be based on the inner product of an index with the component code's parity check matrix. The variant may also comprise applying a sigmoid, or a tanh(x/2) operation, either to the scalar before vectorization, or to all components of all vectors. Followingly, a component-wise multiplication across all vectors is applied. After that, a multi-dimensional inverse discrete Fourier transform variant (IDFT) operation is applied on product generated by the component-wise multiplication, and a log operation may be applied on the result vector. Applying a component-wise logarithm following the inverse discrete Fourier transform may be used to scale the interim result. Followingly, the result vector is mapped to the message structure using a transposed parity check matrix of the component code. These embodiments' complexity is modified from $O(2^d)$ to $O(d\ 2^p)$, and p may be significantly smaller than the component node degree d.

Some implementations are based on Generalized Min-Sum. These variants may start with a vectorization module, which may be preceded or followed by an activation function such as sigmoid or a hyperbolic tangent. Followingly, the absolute value and sign are processed separately for all the components of the vectors. The component-wise min, emphasizing the bit of least confidence, and product operations are applied across all vectors, in a similar way to the product operation in sum-product algorithm. Each of these two modules produces a $2^p$-dimension vector, which may be referred to as gross messages. The product at the output of these two modules is applied component-wise between the two vectors. The resulting vector is provided as an input to a deep neural network (DNN). Moreover, at the last stage, a mapping of the gross messages to the message structure using a transposed parity check matrix of the component code is performed and $L_{hd}$ and $L_o$ are defined similarly to the sum-product algorithm.

Before explaining at least one embodiment in detail, it is to be understood that embodiments are not necessarily limited in its application to the details of construction and the arrangement of the components and/or methods set forth in the following description and/or illustrated in the drawings and/or the Examples. Implementations described herein are capable of other embodiments or of being practiced or carried out in various ways.

Embodiments may be a system, a method, and/or a computer program product. The computer program product may include a computer readable storage medium (or media) having computer readable program instructions thereon for causing a processor to carry out aspects of the embodiments.

A computer readable medium may have instructions stored thereon, which, when executed by a computer, cause the computer to carry out the computer-implemented method or instructions thereof. The computer readable storage medium can be a tangible device that can retain and store instructions for use by an instruction execution device. The computer readable storage medium may be, for example, but is not limited to, an electronic storage device, a magnetic storage device, an optical storage device, an electromagnetic storage device, a semiconductor storage device, or any suitable combination of the foregoing. A non-exhaustive list of more specific examples of the computer readable storage medium includes the following: a portable computer diskette, a hard disk, a random access memory (RAM), a read-only memory (ROM), an erasable programmable read-only memory (EPROM or Flash memory), a static random access memory (SRAM), a portable compact disc read-only memory (CD-ROM), a digital versatile disk (DVD), a memory stick, a floppy disk, and any suitable combination of the foregoing. A computer readable storage medium, as used herein, is not to be construed as being transitory signals per se, such as radio waves or other freely propagating electromagnetic waves, electromagnetic waves propagating through a waveguide or other transmission media (e.g., light pulses passing through a fiber-optic cable), or electrical signals transmitted through a wire.

Computer readable program instructions described herein can be downloaded to respective computing/processing devices from a computer readable storage medium or to an external computer or external storage device via a network, for example, the Internet, a local area network, a wide area network and/or a wireless network. The network may comprise copper transmission cables, optical transmission fibers, wireless transmission, routers, firewalls, switches, gateway computers and/or edge servers. A network adapter card or network interface in each computing/processing device receives computer readable program instructions from the network and forwards the computer readable program instructions for storage in a computer readable storage medium within the respective computing/processing device.

Computer readable program instructions for carrying out operations of embodiments may be assembler instructions, instruction-set-architecture (ISA) instructions, machine instructions, machine dependent instructions, microcode, firmware instructions, state-setting data, or either source code or object code written in any combination of one or more programming languages, including an object oriented programming language such as Smalltalk, C++ or the like, and conventional procedural programming languages, such as the "C" programming language or similar programming languages. The computer readable program instructions may execute entirely on the user's computer, partly on the user's computer, as a stand-alone software package, partly on the user's computer and partly on a remote computer or entirely on the remote computer or server. In the latter scenario, the remote computer may be connected to the user's computer through any type of network, including a local area network (LAN) or a wide area network (WAN), or the connection may be made to an external computer (for example, through the Internet using an Internet Service Provider). In some embodiments, electronic circuitry including, for example, programmable logic circuitry, field-programmable gate arrays (FPGA), or programmable logic arrays (PLA) may execute the computer readable program instructions by utilizing state information of the computer readable program instructions to personalize the electronic circuitry, in order to perform aspects of embodiments.

Aspects of embodiments are described herein with reference to flowchart illustrations and/or block diagrams of methods, apparatus (systems), and computer program products according to embodiments. It will be understood that each block of the flowchart illustrations and/or block diagrams, and combinations of blocks in the flowchart illustrations and/or block diagrams, can be implemented by computer readable program instructions.

These computer readable program instructions may be provided to a processor of a general purpose computer, special purpose computer, or other programmable data processing apparatus to produce a machine, such that the instructions, which execute via the processor of the computer or other programmable data processing apparatus, create means for implementing the functions/acts specified in the flowchart and/or block diagram block or blocks. These computer readable program instructions may also be stored in a computer readable storage medium that can direct a computer, a programmable data processing apparatus, and/or other devices to function in a particular manner, such that the computer readable storage medium having instructions stored therein comprises an article of manufacture including instructions which implement aspects of the function/act specified in the flowchart and/or block diagram block or blocks.

The computer readable program instructions may also be loaded onto a computer, other programmable data processing apparatus, or other device to cause a series of operational steps to be performed on the computer, other programmable apparatus or other device to produce a computer implemented process, such that the instructions which execute on the computer, other programmable apparatus, or other device implement the functions/acts specified in the flowchart and/or block diagram block or blocks.

The flowchart and block diagrams in the Figures illustrate the architecture, functionality, and operation of possible implementations of systems, methods, and computer program products according to various embodiments. In this regard, each block in the flowchart or block diagrams may represent a module, segment, or portion of instructions, which comprises one or more executable instructions for implementing the specified logical function(s). In some alternative implementations, the functions noted in the block may occur out of the order noted in the figures. For example, two blocks shown in succession may, in fact, be executed substantially concurrently, or the blocks may sometimes be executed in the reverse order, depending upon the functionality involved. It will also be noted that each block of the block diagrams and/or flowchart illustration, and combinations of blocks in the block diagrams and/or flowchart illustration, can be implemented by special purpose hardware-based systems that perform the specified functions or acts or carry out combinations of special purpose hardware and computer instructions.

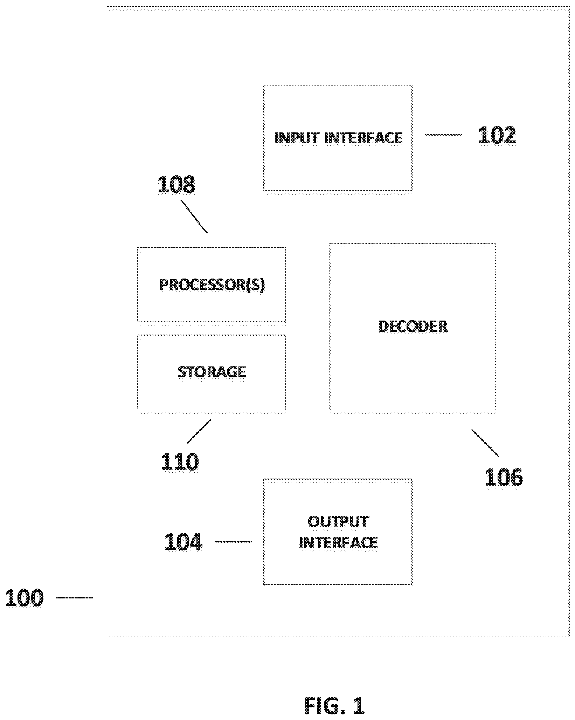

Reference is now made to FIG. 1, which is an exemplary layout of typical components of a decoder system.

As shown in 100, a decoder system may comprise several computation components. As shown in 102, 104 a decoding system may implement input and output interfaces, which may be implemented in software, or firmware. Furthermore, one or more integrated circuits, may be designed to carry out a computer-implemented method or parts thereof, for example by an ASIC or an FPGA. As shown in 106, a decoder is depicted which may be responsible for decoding binary and/or analog segments of predefined lengths, and may use at least one external processor, as depicted in 108, and/or external storage, as depicted in 110.

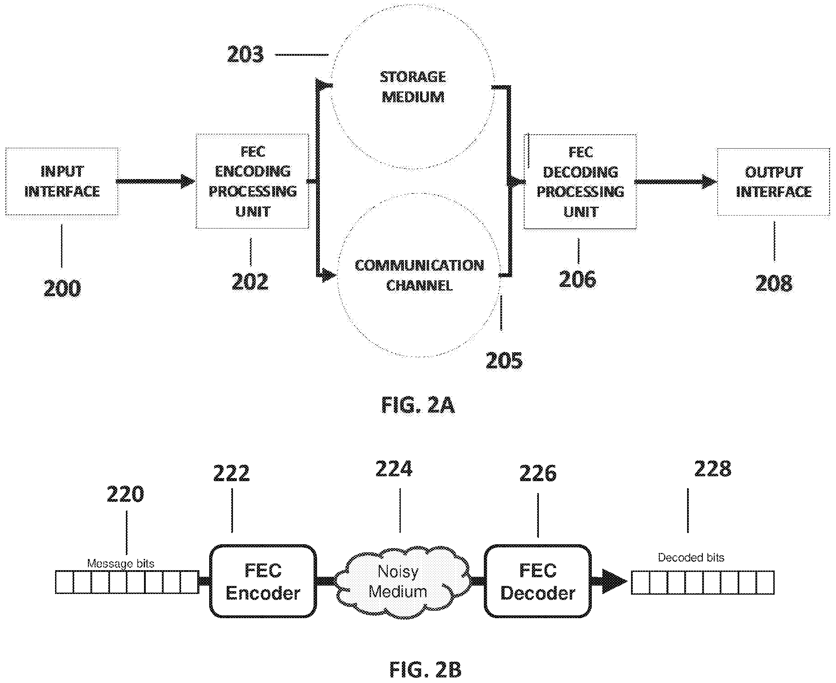

Reference is now made to FIG. 2A, which is an exemplary layout of a typical FEC system and its operation across a noisy communication channel and/or a noisy storage medium.

As shown in 200, an input interface, which receives messages, for example originated from a computer system, communicates with an FEC encoding processing unit, hereby known as an 'encoder', as shown in 202. Optionally, messages may be encoded by the encoder by adding parity bits to the message. As shown in 204, the encoder inputs a coded message through a communication channel, which as shown in 206, is received by an FEC decoding processing unit, hereby known as a 'decoder'. Additionally or alternatively, the encoder may store the data, or the coded message on a storage medium, shown in 203, and the decoder shown in 206 may later retrieve the data from the coded message. The coded message outputted by the communication channel may be noisy, meaning the coded message may be distorted, for example a coded message equal to (1, -1,1, 1) may be outputted by the communication channel as (5, -2, -6, 8). The decoder decodes a noisy message in order to retrieve a decoded message without noise, which is then outputted to an output interface, as shown in 208, which then maybe used, for example, as an output to a computer system.

In this description, it is assumed that a decoding process executed by a decoder involves one or more parity check matrixes, agreed upon with an encoder, that messages received by an encoder are binary, and that codewords transmitted by an encoder over a communication channel are in a bipolar form. This may be implemented, for example, by mapping 0 valued bits to -1 and 1 valued bits to 1. It is further assumed that communication channel and/or storage medium outputs, as mentioned herein, are of block length.

Reference is also now made to FIG. 2B, which is another exemplary schematic diagram of a typical FEC system and its operation across a noisy communication channel.

As shown in 200, an input of raw data or message bits is fed to the FEC encoder shown in 222. The encoded message is transmitted through, or stored on the noisy medium shown on 224, and retrieved by the FEC decoder as shown in 226. The FEC decoder interprets the message, and provided the FEC resilience is adequate to recover the original message bits, the decoded bits shown in 228, match the original message bits shown in 220. The decoder may be as shown in 106 in FIG. 1, receiving the noisy encoded bits from the input interface 102 shown in FIG. 1 and transmitting the decoded message through the output interface 104, also shown in FIG. 1.

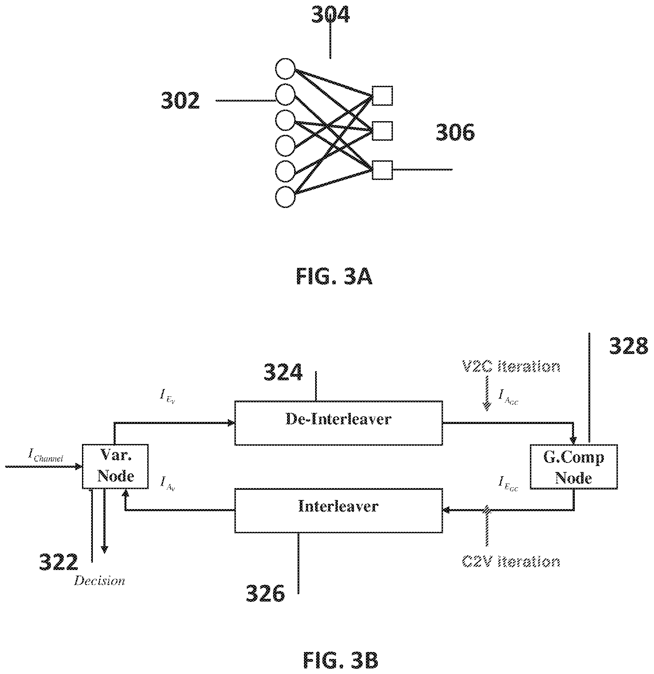

Reference is also now made to FIG. 3A, which is an exemplary tanner graph optionally implemented by a decoder, according to some embodiments of the present invention;

LDPC codes are a sub-class of FEC codes, defined by a sparse parity check matrix, having a low density of non-zero values. The parity check matrix may be interpreted as an adjacency matrix between variable nodes, such as 302, corresponding to the transmitted bits and check nodes, or parity nodes, such as 306, corresponding to the constraints on the transmitted bits.

Thus, the parity check matrix may be depicted by a bipartite Tanner graph, as illustrated in 304. GLDPC decoders may also be represented using a Tanner graph, however while check nodes of LDPC codes perform parity checks, GLDPC check nodes, which may also be referred to as component nodes, shown in 306, apply a component check, based on an additional parity check matrix. GLDPC parity rules may be understood as comprising a component code based on the first parity check matrix, applied for parity checking of a Tanner graph representing an additional parity check matrix. The first parity check matrix may also be referred to as a component code matrix or a component matrix, and as the parity check matrix.

In the simple, exemplary Tanner graph shown, each check node has a degree of three, however practical implementations of LDPC, and GLDPC may have a higher degree such as 10, 12, 15, 20, and even larger number may be ubiquitous in the future. Furthermore, Tanner graphs may have a higher count of variable nodes and component nodes, for example, thousands of variable nodes and component nodes, and future implementations may have millions thereof.

Reference is also made to FIG. 3B, which is an exemplary depiction of a data flow of a method optionally employed by a decoder, according to some embodiments of the present invention. Decoding of GLDPC codes, as well as of LDPC codes, may be a message - passing algorithm, wherein messages, comprising estimates of probabilities, are exchanged between variable nodes and check, or component nodes in an iterative manner. As shown in the figure, the decoder receives noisy $I_{channel}$ from the channel outputs, optionally through the input interface 102 shown in FIG. 1, and stores them as the initial condition at the variable (Var) nodes as depicted in 322. The upper computation path, wherein variable nodes transmit messages to check, parity or component nodes, corresponds to a variable-to-check (V2C) iteration and the de-interleaver shown in 324 distributes messages from variable nodes to their correct check node destinations. Based on the soft values stored at the variable nodes the messages $I_E(V)$, are transmitted through the de-interleaver, forming them as $I_A(GC)$, to the generalized component nodes (GC), also referred to as check nodes, shown in 328.

The opposite, lower computation path, corresponds to a check-to-variable (C2V) iterations. In the V2C iteration, the messages from the check nodes, such as LDPC parity or GLDPC component nodes received as $I_E(GC)$ at the interleaver shown in 326, and interleaved to $I_A(V)$, which is transmitted to the variable nodes shown in 322. The stage may be followed by a check whether all the variable nodes indicate a valid, coherent codeword, when the soft values indicated account for adequate confidence, and/or the like. When the check indicates validity, the decoder may transmit the values of the variable nodes as the message, for example through the output interface 104 shown in FIG. 1, and otherwise it may continue with additional V2C and C2V iterations.

Many variants of this approach exist, which typically differ by the schedule that determines the computation of messages, the expressions for computations, and other factors, many related to practical implementation.

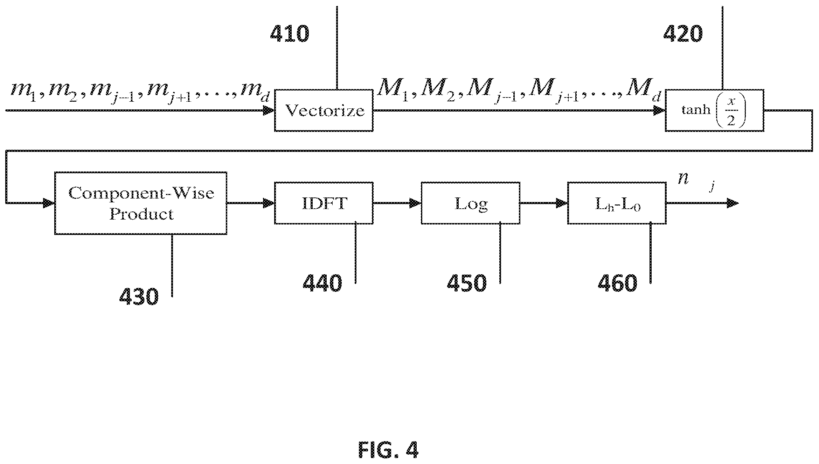

Reference is now made to FIG. 4, which is a schematic diagram of an exemplary generalized sum-product based component node decoder, according to some embodiments of the present invention.

The message bits are received as scalars $m_1, ... , m_d$. These scalar values, may represent an estimation of bit values received from a noisy channel, wherein the bit values originated from a source satisfying parity rules based on an LDPC parity matrix and a component parity check matrix.

The vectorize module shown in 410 converts each scalar to a vector, or a tensor having a length of $2^p$ dimensions, p may be the number of parity bits in the component code's parity check matrix, and accordingly each dimension may correspond to a parity bit.

The vectorize module populates for each scalar one of a plurality of vectors, $M_1, \ldots, M_d$,

An exemplary function by which the associated vector may be populated is:

$$\underline{M}_i[\underline{k}] = \begin{cases} \infty & \underline{k} \cdot \underline{h}_i | \bmod 2 = 0 \\ m_i & Otherwise \end{cases}; i = 1, 2, \ldots, j-1, j+1, \ldots d$$

Note that $\underline{M}_j$ is the corresponding vector, $\underline{k}$ is a vectorized index, $h_i$ is the i'th column of the component parity check matrix. When an inner product of the vectorized index of the vector other than the self-index and the indexed column of the parity check matrix, is a first binary value, for example 0, modulus two, the vectorize module may populate the corresponding vector element with a maximal value.

When the inner product of the index and the indexed column of the parity check matrix is a second binary value modulus two, for example one, or the index equals the self-index, the vectorize module may populate the selected vector element with the scalar value.

Followingly, the tanh(x/2) module shown in 420 may apply the hyperbolic tangent function of half the values of the vectors. The hyperbolic tangent function may be applied in an elementwise or a component-wise manner.

The component-wise product module shown in 430 follows by processing the plurality of vectors using a component-wise multiplication for estimating the bit values. The component-wise multiplication operates on d - 1 vectors of $2^p$ values each and delivers a single output vector of $2^p$ values.

Reference is made to "Design and analysis of nonbinary LDPC codes for arbitrary discrete-memoryless channels" by A. Bennatan and D. Burshtein. Published at IEEE Transactions on Information Theory, 52(2), 549-583. This publication discloses the IDFT operation, which is the inverse multi-dimensional discrete Fourier transform, performed by the IDFT module shown in 440.

The log module shown in 450 transforms the probability domain output of the component-wise module to the LLR domain by extracting the log value from the vector. The output of the log module referred to as gross messages, from which messages are selected and mapped.

The last, $L_{hd}$-$L_0$ module, shown in 460, performs the selection of the relevant elements from $2^p$ sized vectors, which is also referred to as mapping. Two inputs are selected from the vectors:

The '0' output may be selected as

$$L_0 = Log[\underline{0}]$$

The '1' output may selected as

$$L_1 = Log[\underline{h}_j]$$

Wherein $h_j$ is the j'th column of the parity check matrix in integer representation, which may be a number between 0 and $2^p$ - 1, and 0 is the 1st element in the $2^p$ output vector from the log module. At least two types of messages are extractable from the gross messages. One type is a fixed location message. Another type that can be extracted is a pre-mapped message having a corresponding column from the parity check matrix. Note that singular parity check matrixes, actually having a zero column, consist of redundant columns and therefore are not preferred in actual systems. A pre-mapped message, on which the messages are based, may be the pre-mapped message in integer representation, which may be a number between 0 and $2^p$ - 1. Operation may be executed on the 2 vectors, converted to integer representation, which may be a number between 0 and $2^p$ - 1. The messages may be based on the mapping using operations on selected columns from the parity check matrix, a transposed parity check matrix, and/or the like.

When the incoming messages $m_1, \ldots, m_d$, are interpreted as log-likelihood ratio (LLR)s of probabilities corresponding bits are 1, and $n_j$ is the LLR of the a-posteriori probability that bit j is 1, and under the assumption that the random variables corresponding to the assumption that other bits are independent, the messages may be optimal.

The disclosed implementation has linear algorithmic complexity respective to the component node degree, measured in floating point multiplications, $O(d2^{n-k})$. While the computation involves intermediate vector values, the inputs and outputs are scalar.

The tanh(x/2) component is applied component-wise to all vectors. The component-wise product computes a $2^p$

dimensional vector mIDFT denotes the p-dimensional inverse DFT. Specifically, this stage requires only additions and subtractions.

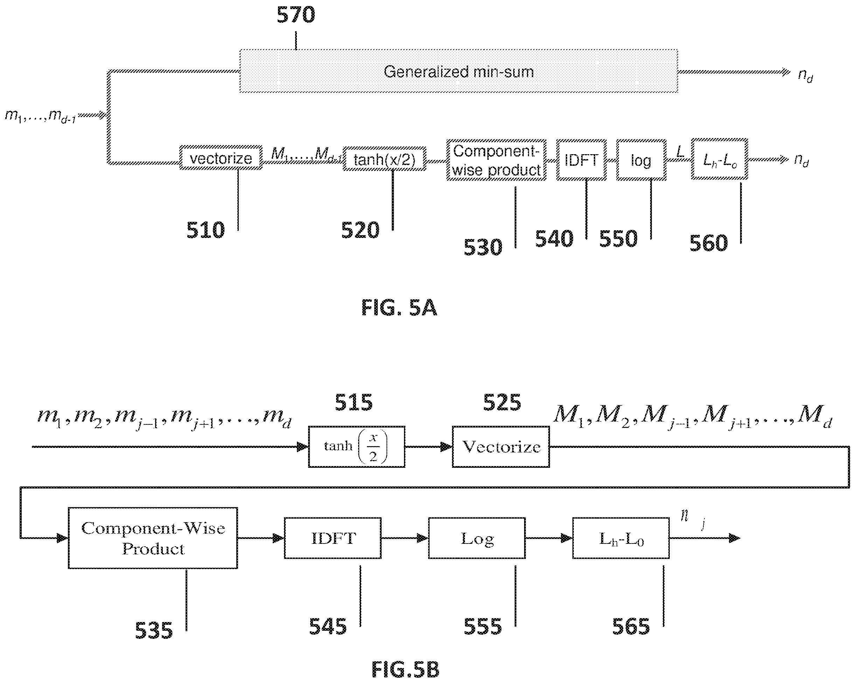

Reference is now made to FIG. 5A, which is a schematic diagram of an exemplary method of training the neural network of the Generalized min-sum component node decoder, according to some embodiments of the present invention. The diagram illustrates a system of training a machine learning based model, such as a neural network, comprised by logic, firmware, software, or combination thereof, which may be used to decode GLDPC messages using the generalized min-sum algorithm.

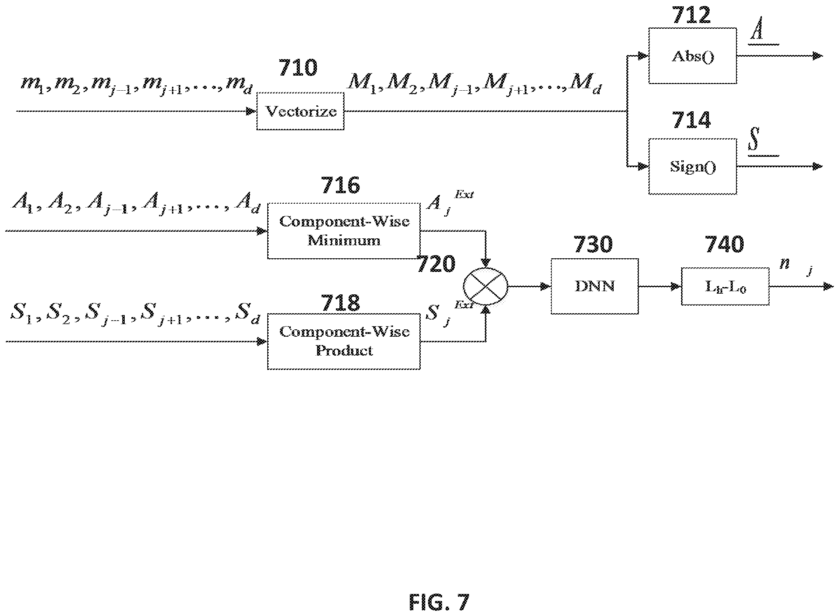

The upper computation path, feeds the incoming messages $m_1, ..., m_d$ as scalars to the generalized min-sum decoder, shown in 570, which comprises a machine learning model, for example a neural network. Further details about the components of the generalized min-sum decoder are illustrated in FIG. 7. The lower computation path, comprising a vectorize module, which may be similar to the vectorize module described in FIG. 4. The vectorize module shown in 510 converts each scalar to a vector, or a tensor, having a dimension of $2^p$, p may be the number of the parity bits in the component code's parity check matrix, $M_1, ..., M_d$.

The vectors are further processed by the tanh(x/2) module shown in 520, the component wise product module shown in 530, the multi-dimensional IDFT module shown in 540, the log module shown in 550, and the $L_{hd}$-$L_0$ module shown in 560.

A method for training may determine, according to algorithms such as gradient descent, derivatives thereof such as Adaptive Gradient Algorithm (AdaGrad), Adam or the likes, or alternatives such as genetic algorithms, or combinations thereof, updated parameters, aiming to teach the network how to imitate the true messages.

When training the Generalized Min-Sum shown in 570, messages from the Sum-Product GLDPC decoder with true data propagating between variable and check nodes, may be utilized as the true data.

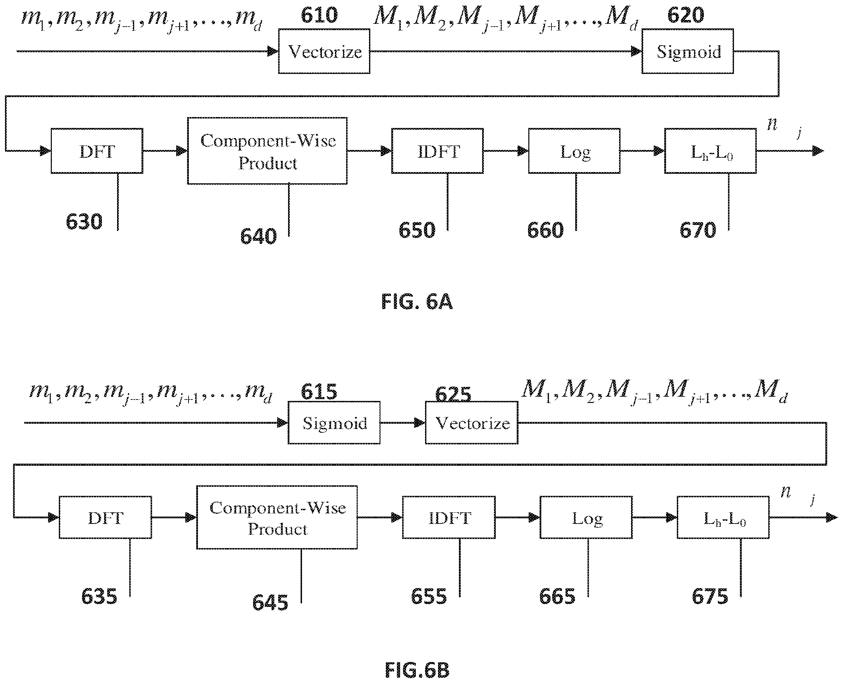

Other methods to train a machine-learning model comprised by a generalized min-sum decoder may also be used. For example, the ground true messages may be derived from the original message before decoding, or an alternative optimal SISO such as proposed in FIG. 5B, FIG. 6A, or FIG. 6B may be implemented.

Reference is also made to FIG. 5B, which is another schematic diagram of an exemplary optimal SISO based component node decoder, according to some embodiments of the present invention.

The message bits are also received as scalars $m_1, ..., m_d$, which may represent an estimation of bit values received from a noisy channel, originating from a source satisfying parity rules based on an LDPC parity matrix and a component parity check matrix.

First, the tanh(x/2) module shown in 515 may apply the hyperbolic tangent function of half the values of the scalers, in an elementwise or a component-wise manner.

Followingly, the vectorize module shown in 525 converts each scalar to a vector, or a tensor having a length of two in p dimensions, p may be the number of parity bits in the component code's parity check matrix, and accordingly each dimension may correspond to a parity bit.

The vectorize module populates for each scalar one of a plurality of vectors, $M_1, ..., M_d$, for example the vector having the same index, by a function of a self-index of the vector, the parity check matrix and the scalar value.

An exemplary function by which the associated vector may be populated is:

$$\underline{M}_i[k] = \begin{cases} 1 & \underline{k} \cdot \underline{h}_i \bmod 2 = 0 \\ m_i & Otherwise \end{cases} ; i = 1, 2, ..., j-1, j+1, ..., d$$

Note that $M_i$ is the corresponding vector, k is a vectorized index, $\underline{h}_i$ is the column of the component parity check matrix indexed by i. When an inner product of the vectorized index of the vector other than the self-index and the indexed column of the parity check matrix, is a first binary value, or example 0, modulus two, the vectorize module may populate the corresponding vector element with a unit value.

When the inner product of the index and the indexed column of the parity check matrix is a second binary value modulus two, for example one, or the index equals the self-index, the vectorize module may populate the selected vector element with the scalar value.

The component-wise product module shown in 535 follows by processing the plurality of vectors using a component-wise multiplication for estimating the bit values, similarly to the implementation disclosed on FIG. 4.

The IDFT operation, performed by the IDFT module shown in 545 similarly to the implementation disclosed on FIG. 4, is based on "Design and analysis of nonbinary LDPC codes for arbitrary discrete-memoryless channels" by A. Bennatan and D. Burshtein. Published at IEEE Transactions on Information Theory, 52(2), 549-583, and reference is made thereto.

The log module shown in 555 transforms the probability domain output of the component-wise module to the LLR domain by extracting the log value from the vectors, thereby generating the gross messages.

The last, $L_{hd}$-$L_0$ module, shown in 565, performs the selection of the relevant element from $2^p$ sized vectors, similarly to the implementation disclosed on FIG. 4, and the messages may be thereby generated using at least one pre-mapped message, the corresponding column from the parity check matrix, and the 1st element from the log module shown in 555. The message may be also based on a fixed location message.

Similarly to the implementation disclosed on FIG. 4, the messages may be optimal provided the scalars are interpreted as LLR of probabilities corresponding bits are 1, under the assumption that the random variables corresponding to the assumption that other bits are independent. The disclosed implementations also has linear algorithmic complexity respective to the component node degree, measured in floating point multiplications, $O(d2^{n-k})$. However, the $tanh(x/2)$ component is applied to the scalars, which require fewer calculations than the implementation disclosed on FIG. 4.

Reference is now made to FIG. 6A, which is yet another schematic diagram of an exemplary optimal SISO based component node decoder, according to some embodiments of the present invention.

The message bits are also received as scalars $m_1, ..., m_d$, which may represent an estimation of a bit value received from a noisy channel, originating from a source satisfying parity rules based on an LDPC parity matrix and a component parity check matrix. First, the vectorize module converts each scalar to a vector, or a tensor having a length of $2^p$ dimensions, p may be the number of parity bits in the component code's parity check matrix, and accordingly each dimension may correspond to a parity bit.

The vectorize module shown in 610 populates for each scalar one of a plurality of vectors, $M_1, ..., M_d$, for example the vector having the same index, by a function of a self-index of the vector, the parity check matrix and the scalar value.

An exemplary function by which the associated vector may be populated is:

$$M_i[\underline{k}] = \begin{cases} -m_i & \underline{k} = 0 \\ m_i & \underline{k} = \underline{h_i} \\ -\infty & Otherwise \end{cases} \quad ; i = 1, 2, \ldots, j-1, j+1, \ldots, d$$

Note that $M_i$ is the corresponding vector, k is a vectorized index, $h_i$ is the column of the component parity check matrix indexed by i.

When the index of the vector matches a column of the parity check matrix other than the self-index, the vectorize module may populate the selected vector element with the scalar value.

When the index of the vector is zero, the vectorize module may populate selected vector element with the scalar value negated.

When the index of the vector is neither zero nor matches a column of the parity check matrix other than the self-index, the vectorize module may populate selected vector element with a maximal negative value.

Followingly, the sigmoid module shown in 620 may apply the sigmoid function of the values of the vector elements, in an elementwise or a component-wise manner. Alternatively, a variant where the sigmoid is applied on the inverted or minus values of the vector elements may be applied. This inversion may be matched by an inversion in the $L_{hd}$-$L_0$ module.

Translation from probabilities to LLR is defined by:

$$L_y = \log\left(\frac{\Pr(y=0)}{\Pr(y=1)}\right)$$

and the inverse translation from LLR to probability is given by:

$$\Pr(y = 0) = \frac{e^{Ly}}{1+e^{Ly}} = \sigma(L_y) \quad \Pr(y = 1) = \frac{1}{1+e^{Ly}} = \sigma(-L_y) \quad .$$

Thus, it's possible to derive the output with either $\sigma(-L_y)$ or $\sigma(L_y)$ as the input, and the selection of the input sign dictates the selection of output sign in the $L_{hd}$-$L_0$ module shown in 670.

The DFT operation, of the DFT module shown in 630 similarly to the implementation disclosed on FIG. 4, is based on "Design and analysis of nonbinary LDPC codes for arbitrary discrete-memoryless channels" by A. Bennatan and D. Burshtein. Published at IEEE Transactions on Information Theory, 52(2), 549-583, and reference is made thereto.

The component-wise product module shown in 640 follows by processing the plurality of vectors using a component-wise multiplication for estimating the bit values, similarly to the implementation disclosed on FIG. 4.

Followingly, an IDFT module may be inserted, as shown in 650. Note that the IDFT or IDFT may be identity up to scaling.

The log module shown in 660 transforms the probability domain output of

the component-wise module to the LLR domain s by extracting the log value from the vectors.

The last, $L_{hd}$-$L_0$ module, shown in 670, performs the selection of the relevant element from $2^p$ sized vectors, similarly to the implementation disclosed on FIG. 4, and the messages may be thereby generated using at least one pre-mapped message, extracted from a corresponding column from the parity check matrix, and a fixed location message.

Similarly to the implementation disclosed on FIG. 4, the messages may be optimal provided the scalars are interpreted as LLR of probabilities corresponding bits are 1, under the assumption that the random variables corresponding to the assumption that other bits are independent. The disclosed implementations also have linear algorithmic complexity respective to the component node degree, measured in floating point multiplications, $O(d2^{n-k})$.

Reference is also now made to FIG. 6B, which is an additional schematic diagram of an exemplary optimal SISO based component node decoder, according to some embodiments of the present invention.

The message bits are also received as scalars $m_1, ... , m_d$ , which may represent an estimation of a bit value received from a noisy channel, originating from a source satisfying parity rules based on an LDPC parity matrix and a component parity check matrix.

First, the sigmoid module shown in 615 may apply the sigmoid function of the values of the scalers, in an elementwise or a component-wise manner.

Followingly, the vectorize module shown in 625 converts each scalar to a vector, or a tensor having a length of two in p dimensions, p may be the number of parity bits in the component code's parity check matrix, and accordingly each dimension may correspond to a parity bit.

The vectorize module populates for each scalar one of a plurality of vectors, $M_1, ... , M_d$ ,for example the vector having the same index, by a function of a self-index of the vector, the parity check matrix and the scalar value.

An exemplary function by which the associated vector may be populated is:

$$M_i\big[\underline{k}\big] = \begin{cases} 1 - m_i & \underline{k} = 0 \\ m_i & \underline{k} = \underline{h_i} \quad ; i = 1, 2, \ldots, j-1, j+1, \ldots, d \\ 0 & Otherwise \end{cases}$$

Note that $M_i$ is the corresponding vector, k is a vectorized index, $h_i$ is the column of the component parity check matrix indexed by i. When the index of the vector matches a column of the parity check matrix other than the self-index, the vectorize module may populate the selected vector element with the scalar value.

When the index of the vector is zero, the vectorize module may populate selected vector element with the scalar value subtracted from a unit value. When the index of the vector is neither zero nor matches a column of the parity check matrix other than the self-index, the vectorize module may populate selected vector element with a zero value.

The DFT module shown in 635, similarly to the implementation disclosed on FIG. 4, is based on "Design and analysis of nonbinary LDPC codes for arbitrary discrete-memoryless channels" by A. Bennatan and D. Burshtein. Published at IEEE Transactions on Information Theory, 52(2), 549-583, and reference is made thereto.

The component-wise product module shown in 645 follows by processing the plurality of vectors using a component-wise multiplication for estimating the bit values, similarly to the implementation disclosed on FIG. 4. A multidimensional IDFT module shown in 655 may perform an IDFT operation.

The log module shown in 665, similarly transforms the probability domain output of the component-wise module to the LLR domain by extracting the log value from the vectors.

The last, $L_{hd}$-$L_0$ module, shown in 675, performs the selection of the relevant element from $2^p$ sized vectors, similarly to the implementation disclosed on FIG. 4, and the messages may be thereby generated using at least one pre-mapped message, derive from a corresponding column from the parity check matrix, and a fixed location message.

Similarly to the implementation disclosed on FIG. 4, the messages may be optimal provided the scalars are interpreted as LLR of probabilities corresponding bits are 1, under the assumption that the random variables corresponding to the assumption that other bits are independent. The disclosed implementation also has linear algorithmic complexity respective to the component node degree, measured in floating point multiplications, $O(d2^{n-k})$. However, the sigmoid component is applied to the scalars, which require fewer calculations than the implementation disclosed on FIG. 4 or 6A.

Reference is now made to FIG. 7, which is a schematic diagram of an exemplary generalized min-sum based component node decoder, according to some embodiments of the present invention.

The message bits are received as scalars $m_1, ... , m_d.$ These scalar values, may represent an estimation of a bit value received from a noisy channel, wherein the bit values originated from a source satisfying parity rules based on an LDPC parity matrix and a component parity check matrix.

The vectorize module shown in 710 converts each scalar to a vector, or a tensor having a length of $2^p$ dimensions, p may be the number of parity bits in the component code's parity check matrix, and accordingly each dimension may correspond to a parity bit.

The vectorize module populates for each scalar one of a plurality of vectors, $M_1, \ldots, M_d$, for example the vector having the same index, by a function of a self-index of the vector, the parity check matrix and the scalar value.

An exemplary function by which the associated vector may be populated is:

$$M_i\left[\underline{k}\right] = \begin{cases} \infty & \underline{k} \cdot \underline{h_i} \big| \mathrm{mod}\, 2 = 0 \\ m_i & Otherwise \end{cases} ; i = 1, 2, \ldots, j-1, j+1, \ldots d$$

Note that $M_i$ is the corresponding vector, k is a vectorized index, $\underline{h_i}$ is the column of the component parity check matrix indexed by i. When an inner product of the vectorized index of the vector other than the self-index and the indexed column of the parity check matrix, is a first binary value, or example 0, modulus two, the vectorize module may populate the corresponding vector element with a maximal value.

When the inner product of the index and the indexed column of the parity check matrix is a second binary value modulus two, for example one, or the index equals the self-index, the vectorize module may populate the selected vector element with the scalar value. Note that other vectorization functions, such as those used in the implementations disclosed in FIG. 5B, FIG. 6A or FIG. 6B.

Followingly, The absolute value of the vector elements are processed in one path $\underline{A}$, as shown in 712 and the signs of the vector elements are processed in another path $\underline{S}$, as_shown in 714. Thereby, splitting the plurality of vectors to an absolute value vector comprising the absolute values of the scalar values and a sign vector indicating the sign of the scalar values, and wherein the component-wise multiplication is applied on the sign vector.

An indexed scalar $A_j^{Ext}$ is generated, as shown in 716, by applying a component-wise or an elementwise minimum function of the absolute values of the vector elements, other than the indexed one, i.e. $A_1, \ldots, A_{j-1}, A_{j+1}, \ldots, A_d$. Another indexed scalar $S_j^{Ext}$ is generated, as shown in 718, by applying a component-wise product function of the signs of the vector elements, as 1 or -1.

The component-wise min and product operations are applied across all vectors, in a similar way to the product operation in sum-product algorithm. Each of these two modules produce a $2^p$-dimenstion vector.

The extracted vectors may be fed to a deep neural network (DNN), which may be trained by prerecorded examples, or by the method shown in FIG. 5A.

The product at the output of these two modules may be applied component-wise between the two vectors, as shown in 720. The resulting vector may also be provided as an input to the DNN.

The DNN, shown in 730, may be fully connected, or apply some assumptions on the problem structure and be based on other connectivity regimes. For example, one or more layers of the DNN may be convolutional.

Since the network output may be processed using the parity check matrix which is of a component code, and the input dimensionality may also be based thereon, inner layers of the neural network may comprises an amount of neurons from an amount of a plurality of neurons, which is a multiple of the $2^p$, where p is the number of the component code's parity bits.

The last, $L_{hd}$-$L_0$ module, shown in 740, performs the selection of the relevant element from $2^p$ sized vectors, similarly to the implementation disclosed on FIG. 4, and the messages may be thereby generated using at least one pre-mapped message, extracted from a corresponding column from the parity check matrix, and a fixed location message.

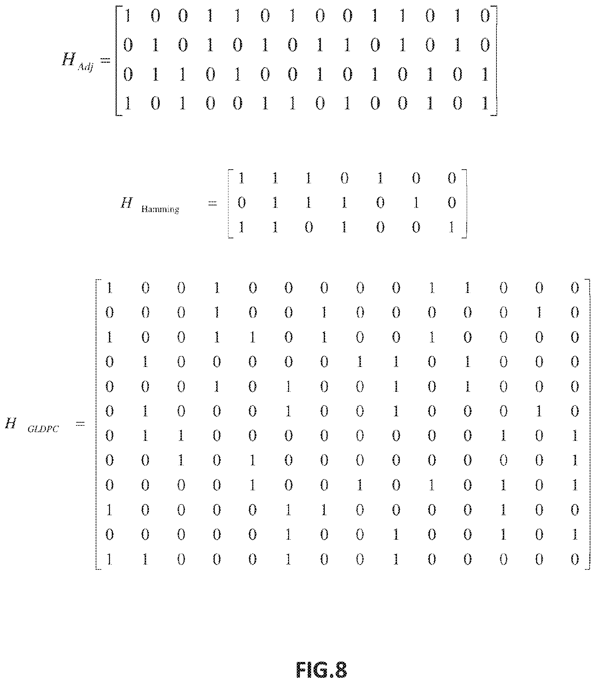

Reference is now made to FIG. 8, which is an exemplary GLDPC parity check matrix, with the associated LDPC and the associated component parity check matrix, according to some embodiments of the present invention.

The first matrix, $H_{Adj}$, is an exemplary Tanner graph adjacency matrix, or an LDPC matrix. Note that the component node degree determines the number of ones each row has, and the number of ones in each column is the variable node degree. Many implementations maintain these numbers constant, other implementations may allow some variance, however such variance would require different matrices for different degree nodes, and high degree variance may lower robustness of the bits associated with nodes having lower degree. Also, note that LDPC matrices may be larger and sparser.

The second matrix, $H_{Hamming}$, is a Hamming (7,4) code parity check matrix The code adds 3 bits of parity to 4 bits of information to deliver 7-bits codewords.

The third matrix $H_{GLDPC}$, has 3 times the number of rows the LDPC matrix has. Each '1' is replaced by a column from the variable node component parity matrix, or the hamming matrix, assigned by the associated variable node. It should be noted that other orders of assignment may be operative, that larger, more complex matrixes may be used, and these exemplary matrixes are shown to clarify the GLDPC implementation and should not be construed as limiting.

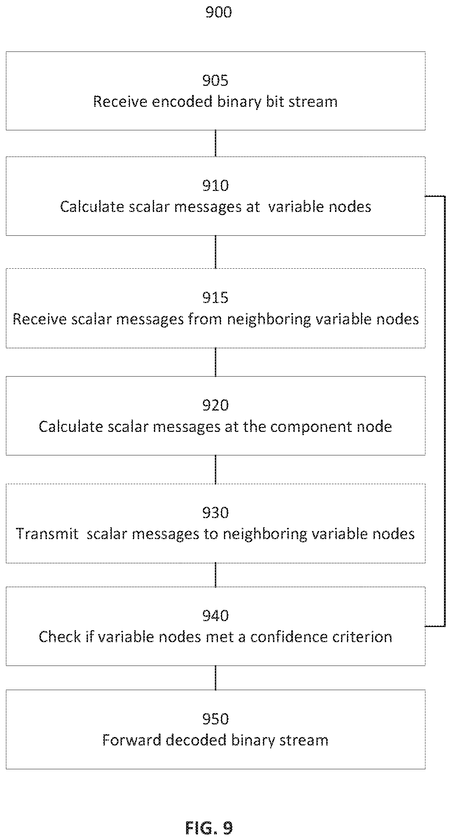

Reference is now made to FIG. 9, which is an exemplary process diagram of a method optionally employed by a decoder, according to some embodiments of the present invention.

The one or more processors 108, dedicated logic, or combination thereof, may execute the exemplary process 900. In some implementations, different processors may be used to implement variable nodes and component nodes.

Alternatively, a processor may implement a plurality of nodes of the same or different types.

The exemplary process 900 starts, as shown in 905, with receiving an encoded binary bit stream at the variable nodes. The bit stream may be received as scalars, representing a LLR of the binary values received from an analog channel.

The exemplary process 900 continues, as shown 910, with calculating scalar messages at variable nodes. The initial messages may be based on the scalar received in 905. Following iterations may update the value. When messages received from neighbor component nodes indicate the binary value indicated is consistent with the protocol, and match a valid component codeword together with messages received from other neighbor variable, the variable node may increase its confidence and increase the absolute value of the scalar. When messages received from neighbor component nodes indicate the binary value indicated is inconsistent with the protocol, and do not match a valid component codeword together with messages received from other neighbor variable, the variable node may decrease the absolute value of the scalar, or flip the scalar to indicate the other binary value. The message sent during following iterations may be based on updated values, which are post-priory in the sense of messages from the neighboring component node neighbors. Note that each iteration may add information based on more remotely connected nodes, for example, after the second iteration, information from indirect variable nodes neighbor of a variable node, at a distance of 4, may propagate to the variable node.

The exemplary process 900 continues, as shown 915, with receiving scalar messages from their neighboring variable nodes. The component nodes receive the messages from their neighbor variable nodes, as determined by the tanner graph. The order of the messages has to be consistent between iterations, however the disclosure does not depend on a specific order. The order may be implemented by deinterleaving, which may be performed by a de-interleaver such as 324 shown in FIG. 3, which may control the variable order and route them to the neighboring component nodes.

The exemplary process 900 continues, as shown 920, with calculating scalar messages at the component node. The calculation may be based on either of the implementations of GLDPC-Sum-product, as described in accordance to FIG. 4, FIG. 5B, FIG. 6A, and FIG 6B, GLDPC Min-sum, as described in accordance to FIG. 7, or variants, combinations thereof, or the like

The exemplary process 900 continues, as shown 930, with transmitting scalar messages to neighboring variable nodes. The messages calculated may be targeted to associated neighboring variable nodes using interleaving. The interleaving, which routes the messages to the associated neighboring variable nodes, may be performed by an interleaver such as 326 shown in FIG. 3.

The exemplary process 900 continues, as shown in 940, with checking if variable nodes met a confidence criterion. Variable nodes may update their value according to messages received from the associated neighboring component nodes. When the variable node receives messages indicating the variable is consistent with a codeword, it may increase its confidence and indicate it, for example by raising the absolute value of the scalar maintained. When the variable node receives messages indicating the variable is inconsistent with the plausible codewords, form many of its neighbors, it may indicate the lower confidence, for example by lowering the variable absolute value, or flipping it should most or all the neighbors indicate the variable is inconsistent. When the confidence meets a certain criterion, such as the absolute value exceeding a certain threshold, it may indicate that, and when the indication from an adequate number of variable nodes, for example all the variable nodes, indicate an adequate confidence, the process may continue to the next, concluding step. When the confidence does not meet the criterion, the process may continue by repeating steps 910 to 940 until the criterion is met, or a timeout criterion aborts the calculation.

The exemplary process 900 concludes, as shown 950, by forward the decoded binary stream. The decoded bits may be processed by one or more additional processes by the same system, for example implementation of a higher level security protocol, or forwarded to another system using the output interface 104 shown in FIG. 1.

Note that this process is shown to put an exemplary context for the disclosed implementations of component nodes, and other processes may apply the one or more of the disclosed methods.

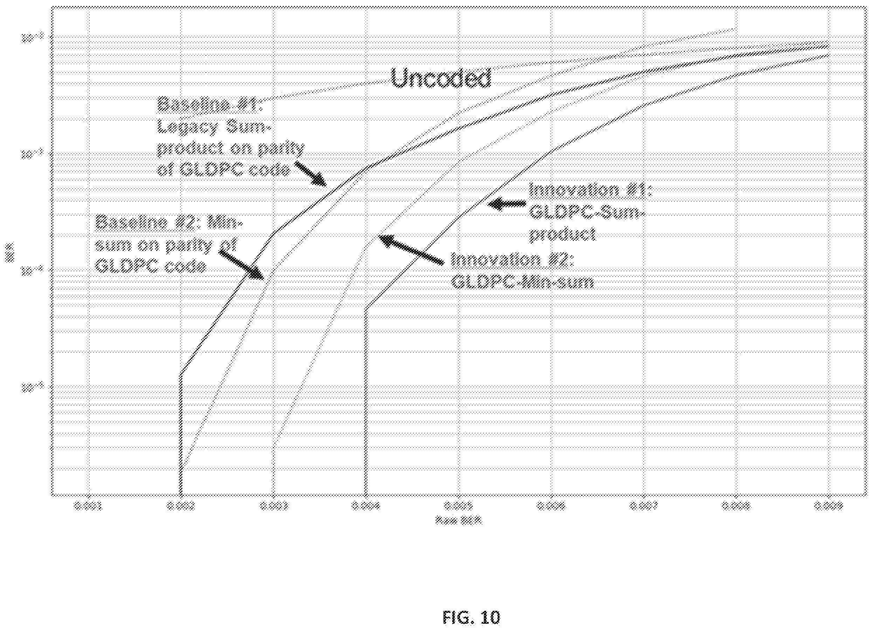

Reference is now made to FIG. 10, which depicts results of simulations using legacy and disclosed implementations of GLDPC parity codes, according to some embodiments of the present invention. As shown in FIG. 10, four decoder implementations of which simulations are compared. The first are the two baseline decoders, namely Legacy Sum-product on parity of GLDPC code represented by the thick line, and Min-sum on parity of GLDPC code by the dotted line. Two implementations of the present disclosure shown are the GLDPC Sum-product represented by the thick line, and the GLDPC Min-sum, by the dotted line. Another dotted line shows the Uuencoded bit error rate (BER). The shape of the Uuencoded bit error rate, which equals the raw BER, is determined by the horizontal axis. The graph shape is derived from that the horizontal axis, which represents the raw BER, is linear, while the vertical axis, representing the BER after the FEC implementation, is logarithmic.

It can be seen that the GLDPC-Sum-product, which may be implemented according to FIG. 4, FIG. 5B, FIG. 6A, and FIG 6B, performs better than all other decoders for all the Raw BER values tested, The GLDPC Min-sum, which may be implemented according to FIG. 7, was second best. The baseline Legacy Sum-product on the overall parity check matrix of the GLDPC code and the other baseline Min-sum on the overall parity check matrix of the GLDPC code performed worse, with the difference in performance increasing for lower raw BER values.

The descriptions of the various embodiments have been presented for purposes of illustration, but are not intended to be exhaustive or limited to the embodiments disclosed. Many modifications and variations will be apparent to those of ordinary skill in the art without departing from the scope of the described embodiments. The terminology used herein was chosen to best explain the principles of the embodiments, the practical application or technical improvement over technologies found in the marketplace, or to enable others of ordinary skill in the art to understand the embodiments disclosed herein.

It is expected that during the life of a patent maturing from this application many relevant hardware design, manufacturing, methods for processing large, sparse, graphs and matrixes, will be developed and the scope of the terms hardware, firmware, and software is intended to include all such new technologies a priori.

As used herein the term "about" refers to ± 10 %.

The terms "comprises", "comprising", "includes", "including", "having" and their conjugates mean "including but not limited to". This term encompasses the terms "consisting of" and "consisting essentially of".

The phrase "consisting essentially of" means that the composition or method may include additional ingredients and/or steps, but only if the additional ingredients and/or steps do not materially alter the basic and novel characteristics of the claimed composition or method.

As used herein, the singular form "a", "an" and "the" include plural references unless the context clearly dictates otherwise. For example, the term "a compound" or "at least one compound" may include a plurality of compounds, including mixtures thereof.

The word "exemplary" is used herein to mean "serving as an example, instance or illustration". Any embodiment described as "exemplary" is not necessarily to be construed as preferred or advantageous over other embodiments and/or to exclude the incorporation of features from other embodiments.

The word "optionally" is used herein to mean "is provided in some embodiments and not provided in other embodiments". Any particular embodiment may include a plurality of "optional" features unless such features conflict.

Throughout this application, various embodiments may be presented in a range format. It should be understood that the description in range format is merely for convenience and brevity and should not be construed as an inflexible limitation on the scope of embodiments. Accordingly, the description of a range should be considered to have specifically disclosed all the possible subranges as well as individual numerical values within that range. For example, description of a range such as from 1 to 6 should be considered to have specifically disclosed subranges such as from 1 to 3, from 1 to 4, from 1 to 5, from 2 to 4, from 2 to 6, from 3 to 6 etc., as well as individual numbers within that range, for example, 1, 2, 3, 4, 5, and 6. This applies regardless of the breadth of the range.

Whenever a numerical range is indicated herein, it is meant to include any cited numeral (fractional or integral) within the indicated range. The phrases "ranging/ranges between" a first indicate number and a second indicate number and "ranging/ranges from" a first indicate number "to" a second indicate number are used herein interchangeably and are meant to include the first and second indicated numbers and all the fractional and integral numerals therebetween.

It is appreciated that certain features of embodiments, which are, for clarity, described in the context of separate embodiments, may also be provided in combination in a single embodiment. Conversely, various features of embodiments, which are, for brevity, described in the context of a single embodiment, may also be provided separately or in any suitable subcombination or as suitable in any other described embodiment. Certain features described in the context of various embodiments are not to be considered essential features of those embodiments, unless the embodiment is inoperative without those elements.

Although embodiments have been described in conjunction with specific embodiments thereof, it is evident that many alternatives, modifications and variations will be apparent to those skilled in the art. Accordingly, it is intended to embrace all such alternatives, modifications and variations that fall within the broad scope of the appended claims. embrace all such alternatives, modifications and variations that fall within the spirit and broad scope of the appended claims.

It is the intent of the applicants that all publications, patents and patent applications referred to in this specification are to be incorporated in their entirety by reference into the specification, as if each individual publication, patent or patent application was specifically and individually noted when referenced that it is to be incorporated herein by reference. In addition, citation or identification of any reference in this application shall not be construed as an admission that such reference is available as prior art to the present invention. To the extent that section headings are used, they should not be construed as necessarily limiting. In addition, any priority document(s) of this application is/are hereby incorporated herein by reference in its/their entirety.

**Claims**

1. A decoder device (226), comprising:
   one or more computation components adapted for:

receiving a number of scalar values $m_1, m_2, ..., m_d$, each representing an estimation of a bit value received from a noisy channel (224), wherein the bit values originated from a source satisfying parity rules comprising a parity check matrix, wherein d is the degree of a check node (306) in a bipartite Tanner graph (304) depicting the parity check matrix;

converting each scalar value $m_i$ to a $2^p$ dimensional vector $M_i$, where p is the number of parity bits in the parity check matrix;

for each scalar value $m_i$, populating one of a plurality of vectors $M_1, M_2 ..., M_d$ by a function of a self-index $i$ of the vector $M_i$, the parity check matrix and the scalar value $m_i$;

processing the plurality of vectors using a component-wise multiplication for estimating the bit values, wherein the component-wise multiplication operates on d - 1 vectors of $2^p$ values each and delivers a single output vector of $2^p$ value;

applying inverse multidimensional discrete Fourier transform on the single output vector generated by the component-wise multiplication;

outputting gross messages by applying a component-wise logarithm following the inverse discrete Fourier transform; and

extracting at least two types of messages from the gross messages, wherein one type is a fixed location message, and another type is a pre-mapped message having a corresponding column from the parity check matrix.

2. The device of claim 1, the one or more computation components being further adapted for applying an elementwise function of a sigmoid function on the the scalar values $m_i$.

3. The device of claim 1, the one or more computation components being further adapted for applying an elementwise function of a hyperbolic tangent on half the the scalar values $m_i$.

4. The device of claim 1, the one or more computation components being further adapted for splitting the plurality of vectors to an absolute value vector comprising the absolute values of the scalar values and a sign vector indicating the sign of the scalar values, and wherein the component-wise multiplication is applied on the sign vector.

5. The device of claim 4, the one or more computation components being further adapted for applying an elementwise minimum on the absolute value vector.

6. A computer-implemented method used for decoding, comprising:

receiving a number of scalar values $m_1, m_2, ..., m_d$, each representing an estimation of a bit value received from a noisy channel (224), wherein the bit values originated from a source satisfying parity rules comprising a parity check matrix, wherein d is the degree of a check node (306) in a bipartite Tanner graph (304) depicting the parity check matrix;

converting each scalar value $m_i$ to a $2^p$ dimensional vector $M_i$, where p is the number of parity bits in the parity check matrix;

for each scalar value $m_i$, populating one of a plurality of vectors $M_1, M_2 ..., M_d$ by a function of a self-index $i$ of the vector $M_i$, the parity check matrix and the scalar value $m_i$;

processing the plurality of vectors using a component-wise multiplication for estimating the bit values, wherein the component-wise multiplication operates on d - 1 vectors of $2^p$ values each and delivers a single output vector of $2^p$ value;

applying inverse multidimensional discrete Fourier transform on the single output vector generated by the component-wise multiplication;

outputting gross messages by applying a component-wise logarithm following the inverse discrete Fourier transform; and

extracting at least two types of messages from the gross messages, wherein one type is a fixed location message, and another type is a pre-mapped message having a corresponding column from the parity check matrix.

7. The computer-implemented method of claim 6, further comprising applying an elementwise function of a sigmoid function on the scalar values $m_i$.

8. The computer-implemented method of claim 6, further comprising applying an elementwise function of a hyperbolic tangent on half the scalar values $m_i$.

9. The computer-implemented method of claim 6, further comprising splitting the plurality of vectors to an absolute value vector comprising the absolute values of the scalar values $m_i$ and a sign vector indicating the sign of the scalar values $m_i$, and wherein the component-wise multiplication is applied on the sign vector.

10. The computer-implemented method of claim 6, wherein the parity rules comprise a component code based on the parity check matrix, applied for parity checking of the bipartite Tanner graph producing an additional parity check matrix.

11. A computer readable medium having instructions stored thereon, which, when executed by a computer, cause the computer to carry out the computer-implemented method of any one of claims 6 to 10.

12. An integrated circuit, designed to carry out the computer-implemented method of any one of claims 6 to 10.

**Patentansprüche**

1. Decodierervorrichtung (226), umfassend:
   eine oder mehrere Rechenkomponenten, die zu Folgendem angepasst sind:

   Empfangen einer Anzahl von Skalarwerten $m_1$, $m_2$, ..., $m_d$, die jeweils eine Schätzung eines Bitwerts darstellen, der von einem verrauschten Kanal (224) empfangen wird, wobei die Bitwerte von einer Quelle stammen, die Paritätsregeln erfüllt, umfassend eine Paritätsprüfmatrix, wobei d der Grad eines Prüfknotens (306) in einem zweiteiligen Tanner-Diagramm (304) ist, das die Paritätsprüfmatrix abbildet;
   Konvertieren jedes Skalarwerts $m_i$ in einen $2^p$-dimensionalen Vektor $M_i$, wo p die Anzahl von Paritätsbits in der Paritätsprüfmatrix ist;
   für jeden Skalarwert $m_i$, Befüllen eines von einer Vielzahl von Vektoren $M_1$, $M_2$..., $M_d$ durch eine Funktion eines Selbstindex *i* des Vektors $M_i$, der Paritätsprüfmatrix und des Skalarwerts $m_i$;
   Verarbeiten der Vielzahl von Vektoren unter Verwendung einer komponentenweisen Multiplikation zum Schätzen der Bitwerte, wobei die komponentenweise Multiplikation auf d-1 Vektoren mit jeweils $2^p$ Werten angewendet wird und einen einzelnen Ausgabevektor mit $2^p$ Werten liefert;
   Anwenden einer inversen mehrdimensionalen diskreten Fouriertransformation auf den einzelnen Ausgangsvektor, der durch die komponentenweise Multiplikation erzeugt wird;
   Ausgeben von Bruttonachrichten durch das Anwenden eines komponentenweisen Logarithmus nach der inversen diskreten Fouriertransformation; und
   Extrahieren von mindestens zwei Arten von Nachrichten aus den Bruttonachrichten, wobei eine Art eine Nachricht mit festem Standort ist und eine andere Art eine vorab kartierte Nachricht ist, die eine entsprechende Spalte aus der Paritätsprüfungsmatrix aufweist.

2. Vorrichtung nach Anspruch 1, wobei die eine oder die mehreren Rechenkomponenten ferner zum Anwenden einer elementweisen Funktion einer Sigmoidfunktion auf die Skalarwerte $m_i$ angepasst sind.

3. Vorrichtung nach Anspruch 1, wobei die eine oder die mehreren Rechenkomponenten ferner zum Anwenden einer elementweisen Funktion eines hyperbolischen Tangens auf die Hälfte der Skalarwerte $m_i$ angepasst sind.

4. Vorrichtung nach Anspruch 1, wobei die eine oder die mehreren Rechenkomponenten ferner zum Aufteilen der Vielzahl von Vektoren in einen Absolutwertvektor angepasst sind, umfassend die Absolutwerte der Skalarwerte und einen Vorzeichenvektor, der das Vorzeichen der Skalarwerte angibt, und wobei die komponentenweise Multiplikation auf den Vorzeichenvektor angewendet wird.

5. Vorrichtung nach Anspruch 4, wobei die eine oder die mehreren Rechenkomponenten ferner zum Anwenden eines elementweisen Minimums auf den Absolutwertvektor angepasst sind.

6. Computerimplementiertes Verfahren, das zum Decodieren verwendet wird, umfassend:

   Empfangen einer Anzahl von Skalarwerten $m_1$, $m_2$, ..., $m_d$, die jeweils eine Schätzung eines Bitwerts darstellen, der von einem verrauschten Kanal (224) empfangen wird, wobei die Bitwerte von einer Quelle stammen, die Paritätsregeln erfüllt, umfassend eine Paritätsprüfmatrix, wobei d der Grad eines Prüfknotens (306) in einem zweiteiligen Tanner-Diagramm (304) ist, das die Paritätsprüfmatrix abbildet;
   Konvertieren jedes Skalarwerts in einen $2^p$-dimensionalen Vektor $M_i$ where p is the number of parity bits in the parity check matrix;, wo p die Anzahl von Paritätsbits in der Paritätsprüfmatrix ist;

für jeden Skalarwert $m_i$, Befüllen eines von einer Vielzahl von Vektoren $M_1$, $M_{2\,...}$, $M_d$ durch eine Funktion eines Selbstindex i des Vektors $M_i$, der Paritätsprüfmatrix und des Skalarwerts $m_i$;

Verarbeiten der Vielzahl von Vektoren unter Verwendung einer komponentenweisen Multiplikation zum Schätzen der Bitwerte, wobei die komponentenweise Multiplikation auf d-1 Vektoren mit jeweils $2^p$ Werten angewendet wird und einen einzelnen Ausgabevektor mit $2^p$ Werten liefert;

Anwenden einer inversen mehrdimensionalen diskreten Fouriertransformation auf den einzelnen Ausgangsvektor, der durch die komponentenweise Multiplikation erzeugt wird;

Ausgeben von Bruttonachrichten durch das Anwenden eines komponentenweisen Logarithmus nach der inversen diskreten Fouriertransformation; und

Extrahieren von mindestens zwei Arten von Nachrichten aus den Bruttonachrichten, wobei eine Art eine Nachricht mit festem Standort ist und eine andere Art eine vorab kartierte Nachricht ist, die eine entsprechende Spalte aus der Paritätsprüfungsmatrix aufweist.

7. Computerimplementiertes Verfahren nach Anspruch 6, ferner umfassend Anwenden einer elementweisen Funktion einer Sigmoidfunktion auf die Skalarwerte $m_i$.

8. Computerimplementiertes Verfahren nach Anspruch 6, ferner umfassend Anwenden einer elementweisen Funktion eines hyperbolischen Tangens auf die Hälfte der Skalarwerte $m_i$.

9. Computerimplementiertes Verfahren nach Anspruch 6, ferner umfassend Aufteilen der Vielzahl von Vektoren in einen Absolutwertvektor, umfassend die Absolutwerte der Skalarwerte $m_i$ und einen Vorzeichenvektor, der das Vorzeichen der Skalarwerte $m_i$ angibt, und wobei die komponentenweise Multiplikation auf den Vorzeichenvektor angewendet wird.

10. Computerimplementiertes Verfahren nach Anspruch 6, wobei die Paritätsregeln einen Code einer Komponente basierend auf der Paritätsprüfmatrix umfassen, angewendet für Paritätsprüfen des zweiteiligen Tanner-Diagramms, wobei eine zusätzliche Paritätsprüfmatrix produziert wird.

11. Computerlesbares Medium, das darauf gespeicherte Anweisungen aufweist, die, wenn sie durch einen Computer ausgeführt werden, den Computer dazu veranlassen, das computerimplementierte Verfahren nach einem der Ansprüche 6 bis 10 durchzuführen.

12. Integrierte Schaltung, die dazu ausgestaltet ist, das computerimplementierte Verfahren nach einem der Ansprüche 6 bis 10 durchzuführen.

**Revendications**

1. Dispositif décodeur (226), comprenant :
un ou plusieurs composants de calcul adaptés pour :

la réception d'un certain nombre de valeurs scalaires, $m_1$, $m_{2,\,...}$, $m_d$ représentant chacune une estimation d'une valeur de bit reçue d'un canal bruyant (224), dans lequel les valeurs de bit proviennent d'une source satisfaisant des règles de parité comprenant une matrice de contrôle de parité, dans lequel d est le degré d'un nœud de contrôle (306) dans un graphe de Tanner bipartite (304) représentant la matrice de contrôle de parité ;

la conversion de chaque valeur scalaire $m_i$ en un vecteur bidimensionnel $2^p$ $M_i$, où p est le nombre de bits de parité dans la matrice de contrôle de parité ;

pour chaque valeur scalaire $m_i$ remplissant l'une d'une pluralité de vecteurs $M_1$, $M_{2...}$, $M_d$ par une fonction d'un auto-indice $i$ du vecteur $M_i$, la matrice de contrôle de parité et la valeur scalaire $m_i$ ;

le traitement de la pluralité de vecteurs à l'aide d'une multiplication par composant pour l'estimation des valeurs de bits, dans lequel la multiplication par composant opère sur d-1 vecteurs de valeurs $2^p$ chacun et délivre un seul vecteur de sortie de valeur $2^p$ ;

l'application d'une transformée de Fourier discrète multidimensionnelle inverse sur le vecteur de sortie unique généré par la multiplication par composant ;

la délivrance en sortie des messages bruts en appliquant un logarithme par composant suivant la transformée de Fourier discrète inverse ; et

l'extraction d'au moins deux types de messages à partir des messages bruts, dans lequel un type est un message à emplacement fixe, et un autre type est un message pré-mappé ayant une colonne correspondante de la matrice de contrôle de parité.

2. Dispositif selon la revendication 1, les un ou plusieurs composants de calcul étant également adaptés pour l'application d'une fonction par élément d'une fonction sigmoïde sur les valeurs scalaires $m_i$.

3. Dispositif selon la revendication 1, les un ou plusieurs composants de calcul étant également adaptés pour l'application d'une fonction par élément d'une tangente hyperbolique sur la moitié des valeurs scalaires $m_i$.

4. Dispositif selon la revendication 1, les un ou plusieurs composants de calcul étant également adaptés pour diviser la pluralité de vecteurs en un vecteur de valeur absolue comprenant les valeurs absolues des valeurs scalaires et un vecteur de signes indiquant le signe des valeurs scalaires, et dans lequel la multiplication par composant est appliquée sur le vecteur de signes.

5. Dispositif selon la revendication 4, les un ou plusieurs composants de calcul étant également adaptés pour l'application d'un minimum par élément sur le vecteur de valeur absolue.

6. Procédé mis en œuvre par ordinateur utilisé pour le décodage, comprenant :

la réception d'un certain nombre de valeurs scalaires, $m_1, m_2, \dots, m_d,$ représentant chacune une estimation d'une valeur de bit reçue d'un canal bruyant (224), dans lequel les valeurs de bit proviennent d'une source satisfaisant des règles de parité comprenant une matrice de contrôle de parité, dans lequel d est le degré d'un nœud de contrôle (306) dans un graphe de Tanner bipartite (304) représentant la matrice de contrôle de parité ;
la conversion de chaque valeur scalaire en un vecteur dimensionnel $2^p$ $M_i$, où p est le nombre de bits de parité dans la matrice de contrôle de parité ;
pour chaque valeur scalaire $m_i$ remplissant l'une d'une pluralité de vecteurs $M_1, M_2\dots, M_d$ par une fonction d'un auto-indice $i$ du vecteur $M_i$ la matrice de contrôle de parité et la valeur scalaire $m_i$ ;
le traitement de la pluralité de vecteurs à l'aide d'une multiplication par composant pour l'estimation des valeurs de bits, dans lequel la multiplication par composant opère sur d-1 vecteurs de valeurs $2^p$ chacun et délivre un seul vecteur de sortie de valeur $2^p$ ;
l'application d'une transformée de Fourier discrète multidimensionnelle inverse sur le vecteur de sortie unique généré par la multiplication par composant ;
la délivrance en sortie des messages bruts en appliquant un logarithme par composant suivant la transformée de Fourier discrète inverse ; et
l'extraction d'au moins deux types de messages à partir des messages bruts, dans lequel un type est un message à emplacement fixe, et un autre type est un message pré-mappé ayant une colonne correspondante de la matrice de contrôle de parité.

7. Procédé mis en œuvre par ordinateur selon la revendication 6, comprenant également l'application d'une fonction par élément d'une fonction sigmoïde sur les valeurs scalaires $m_i$.

8. Procédé mis en œuvre par ordinateur selon la revendication 6, comprenant également l'application d'une fonction par élément d'une tangente hyperbolique sur la moitié des valeurs scalaires $m_i$.

9. Procédé mis en œuvre par ordinateur selon la revendication 6, comprenant également la division de la pluralité de vecteurs en un vecteur de valeur absolue comprenant les valeurs absolues des valeurs scalaires $m_i$ et un vecteur de signes indiquant le signe des valeurs scalaires $m_i$, et dans lequel la multiplication par composant est appliquée sur le vecteur de signes.

10. Procédé mis en œuvre par ordinateur selon la revendication 6, dans lequel les règles de parité comprennent un code de composant basé sur la matrice de contrôle de parité, appliqué pour le contrôle de parité du graphe de Tanner bipartite produisant une matrice de contrôle de parité supplémentaire.

11. Support lisible par ordinateur ayant des instructions stockées sur celui-ci, qui, lorsqu'elles sont exécutées par un ordinateur, amènent l'ordinateur à mettre en œuvre le procédé mis en œuvre par ordinateur selon l'une quelconque des revendications 6 à 10.

12. Circuit intégré, conçu pour mettre en œuvre le procédé mis en œuvre par ordinateur selon l'une quelconque des revendications 6 à 10.

INPUT INTERFACE — 102

108

PROCESSOR(S)

STORAGE

DECODER

110

106

104 —— OUTPUT INTERFACE

100 —

FIG. 1

FIG. 2A

FIG. 2B

304

302

306

**FIG. 3A**

328

V2C iteration

324

$I_{E_V}$

$I_{A_{GC}}$

De-Interleaver

$I_{Channel}$

Var.
Node

G.Comp
Node

$I_{A_V}$

$I_{E_{GC}}$

Interleaver

322

*Decision*

326

C2V iteration

**FIG. 3B**

$$m_1, m_2, m_{j-1}, m_{j+1}, \ldots, m_d \quad \boxed{\text{Vectorize}} \quad M_1, M_2, M_{j-1}, M_{j+1}, \ldots, M_d \quad \boxed{\tanh\left(\frac{x}{2}\right)}$$

**410**

**420**

Component-Wise Product $\quad$ IDFT $\quad$ Log $\quad$ $L_h\text{-}L_0$ $\qquad n_j$

**430** $\qquad$ **440** $\qquad$ **450** $\qquad$ **460**

FIG. 4

**570**

Generalized min-sum — $n_d$

$m_1,\ldots,m_{d-1}$

vectorize — $M_1,\ldots,M_{d-1}$ — tanh(x/2) — Component-wise product — IDFT — log — $L$ — $L_h$-$L_o$ — $n_d$

**510**    **520**    **530**    **540**    **550**    **560**

**FIG. 5A**

$m_1, m_2, m_{j-1}, m_{j+1}, \ldots, m_d$    **515**    **525**    $M_1, M_2, M_{j-1}, M_{j+1}, \ldots, M_d$

$\tanh\left(\dfrac{x}{2}\right)$    Vectorize

Component-Wise Product    IDFT    Log    $L_h$-$L_o$    $n_j$

**535**    **545**    **555**    **565**

**FIG. 5B**

$m_1, m_2, m_{j-1}, m_{j+1}, \ldots, m_d$ **610** $M_1, M_2, M_{j-1}, M_{j+1}, \ldots, M_d$ **620**

Vectorize

Sigmoid

DFT

Component-Wise Product

IDFT

Log

$L_h$-$L_0$

$n$ $j$

**630**

**640**

**650**

**660**

**670**

FIG. 6A

$m_1, m_2, m_{j-1}, m_{j+1}, \ldots, m_d$ **615** **625** $M_1, M_2, M_{j-1}, M_{j+1}, \ldots, M_d$

Sigmoid

Vectorize

DFT

Component-Wise Product

IDFT

Log

$L_h$-$L_0$

$n$ $j$

**635**

**645**

**655**

**665**

**675**

FIG.6B

FIG. 7

EP 4 233 177 B1

$$H_{Adj} = \begin{bmatrix} 1 & 0 & 0 & 1 & 1 & 0 & 1 & 0 & 0 & 1 & 1 & 0 & 1 & 0 \\ 0 & 1 & 0 & 1 & 0 & 1 & 0 & 1 & 1 & 0 & 1 & 0 & 1 & 0 \\ 0 & 1 & 1 & 0 & 1 & 0 & 0 & 1 & 0 & 1 & 0 & 1 & 0 & 1 \\ 1 & 0 & 1 & 0 & 0 & 1 & 1 & 0 & 1 & 0 & 0 & 1 & 0 & 1 \end{bmatrix}$$

$$H_{Hamming} = \begin{bmatrix} 1 & 1 & 1 & 0 & 1 & 0 & 0 \\ 0 & 1 & 1 & 1 & 0 & 1 & 0 \\ 1 & 1 & 0 & 1 & 0 & 0 & 1 \end{bmatrix}$$

$$H_{GLDPC} = \begin{bmatrix} 1 & 0 & 0 & 1 & 0 & 0 & 0 & 0 & 0 & 1 & 1 & 0 & 0 & 0 \\ 0 & 0 & 0 & 1 & 0 & 0 & 1 & 0 & 0 & 0 & 0 & 0 & 1 & 0 \\ 1 & 0 & 0 & 1 & 1 & 0 & 1 & 0 & 0 & 1 & 0 & 0 & 0 & 0 \\ 0 & 1 & 0 & 0 & 0 & 0 & 0 & 1 & 1 & 0 & 1 & 0 & 0 & 0 \\ 0 & 0 & 0 & 1 & 0 & 1 & 0 & 0 & 1 & 0 & 1 & 0 & 0 & 0 \\ 0 & 1 & 0 & 0 & 0 & 1 & 0 & 0 & 1 & 0 & 0 & 0 & 1 & 0 \\ 0 & 1 & 1 & 0 & 0 & 0 & 0 & 0 & 0 & 0 & 0 & 1 & 0 & 1 \\ 0 & 0 & 1 & 0 & 1 & 0 & 0 & 0 & 0 & 0 & 0 & 0 & 0 & 1 \\ 0 & 0 & 0 & 0 & 1 & 0 & 0 & 1 & 0 & 1 & 0 & 1 & 0 & 1 \\ 1 & 0 & 0 & 0 & 0 & 1 & 1 & 0 & 0 & 0 & 0 & 1 & 0 & 0 \\ 0 & 0 & 0 & 0 & 0 & 1 & 0 & 0 & 1 & 0 & 0 & 1 & 0 & 1 \\ 1 & 1 & 0 & 0 & 0 & 1 & 0 & 0 & 1 & 0 & 0 & 0 & 0 & 0 \end{bmatrix}$$

FIG.8

900

```
┌─────────────────────────────────────────────────────┐
│                        905                          │
│            Receive encoded binary bit stream        │
└─────────────────────────────────────────────────────┘
                          │
┌─────────────────────────────────────────────────────┐
│                        910                          │
│        Calculate scalar messages at  variable nodes │
└─────────────────────────────────────────────────────┘
                          │
┌─────────────────────────────────────────────────────┐
│                        915                          │
│  Receive scalar messages from neighboring variable nodes │
└─────────────────────────────────────────────────────┘
                          │
┌─────────────────────────────────────────────────────┐
│                        920                          │
│      Calculate scalar messages at the component node │
└─────────────────────────────────────────────────────┘
                          │
┌─────────────────────────────────────────────────────┐
│                        930                          │
│  Transmit  scalar messages to neighboring variable nodes │
└─────────────────────────────────────────────────────┘
                          │
┌─────────────────────────────────────────────────────┐
│                        940                          │
│     Check if variable nodes met a confidence criterion │
└─────────────────────────────────────────────────────┘
                          │
┌─────────────────────────────────────────────────────┐
│                        950                          │
│            Forward decoded binary stream            │
└─────────────────────────────────────────────────────┘
```

FIG. 9

FIG. 10

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 2004088645 A1

### Non-patent literature cited in the description

- Simple MAP Decoding of First-Order Reed-Muller and Hamming Codes. **ASHIKHMIN A et al.** IEEE TRANSACTIONS ON INFORMATION THEORY. IEEE, 01 August 2004, vol. 50, 1812-1818
- Use of fast Walsh-Hadamard transformation for optimal symbol-by-symbol binary block-code decoding. **NAZAROV L E et al.** ELECTRONICS LETTERS. THE INSTITUTION OF ENGINEERING AND TECHNOLOGY, 05 February 1998, vol. 34, 261-262
- An optimum symbol-by-symbol decoding rule for linear codes. **HARTMANN CARLOS R P et al.** IEEE TRANSACTIONS ON INFORMATION THEORY. IEEE, 01 September 1976, vol. 22, 514-517
- Codes on Graphs: Normal Realizations. **DAVID FORNEYJR G**. IEEE TRANSACTIONS ON INFORMATION THEORY. IEEE, 01 February 2001, vol. 47
- **A. BENNATAN** ; **D. BURSHTEIN**. Design and analysis of nonbinary LDPC codes for arbitrary discrete-memoryless channels. *IEEE Transactions on Information Theory*, vol. 52 (2), 549-583